# EUROPÄISCHE PATENTSCHRIFT

(11) **EP 1 307 963 B1**
(45) Veröffentlichungstag und Bekanntmachung des Hinweises auf die Patenterteilung: **12.03.2008**
(21) Anmeldenummer: 01969220.1
(22) Anmeldetag: 07.08.2001
(51) Int. Cl.: H03J 5/24

(54) **HOCHFREQUENZ-EINGANGSSTUFE**
HIGH FREQUENCY INPUT STAGE
ETAGE D'ENTREE HAUTE FREQUENCE

(30) Priorität: 10.08.2000 DE 10039191
(43) Veröffentlichungstag der Anmeldung: 07.05.2003
(73) Patentinhaber: Infineon Technologies AG, 81669 München (DE)
(72) Erfinder: SIM, Sanggyu, 81739 München (DE)
(74) Vertreter: Epping - Hermann - Fischer
(86) Internationale Anmeldenummer: PCT/DE2001/003012
(87) Internationale Veröffentlichungsnummer: WO 2002/013383

(56) Entgegenhaltungen:
- EP-A- 0 299 578
- WO-A-00/11783
- GB-A- 202 111
- GB-A- 864 444
- US-A- 1 493 600
- US-A- 3 559 089
- US-A- 4 771 332
- US-A- 4 888 568
- US-A- 4 956 710
- US-A- 5 978 663
- PATENT ABSTRACTS OF JAPAN vol. 008, no. 142 (E-254), 3. Juli 1984 (1984-07-03) & JP 59 051617 A (SHARP KK), 26. März 1984 (1984-03-26)
- STEJSKAL F.: 'Elekronik-Taschenbuch', FERD. DÜMMLERS VERLAG BONN, 1977, ISBN 3-427-53282-8 ISBN 3-427-53282-8 * Anhang: Schaltplan Grundig CONCERT Boy 1000 (zu Seite 118 ff.) * * Seiten 62,63 *
- 1971, NORDMENDE ZENTRALKUNDENDIENST Service-Information (3.Auflage - 3.Edition) Chassis Uni 21/771.220.A00

## Beschreibung

Die vorliegende Erfindung betrifft eine Hochfrequenz-Eingangsstufe mit einem Hochfrequenz-Koppelelement, dem ein Eingangssignal zuführbar ist und das mit einem ersten und mit einem zweiten abstimmbaren Hochfrequenz-Resonanzkreis, welche eingangsseitig miteinander verbunden sind, gekoppelt ist.

In Zweiband- und Dreiband-TV-Tunern sind üblicherweise Hochfrequenz-Eingangsstufen (Frontend) mit zueinander parallelgeschalteten, abstimmbaren und für verschiedene Frequenzbänder ausgelegten Hochfrequenz-Resonanzkreisen vorgesehen.

In der Druckschrift EP 0 299 578 A1 ist ein Hochfrequenz-Eingangsschaltkreis, welcher gattungsbildend ist, angegeben. Dort ist ein Hochfrequenz-Koppelelement einerseits mit einer Antenne und andererseits mit je einem ersten, einem zweiten und einem dritten Hochfrequenz-Resonanzkreis verbunden. Das Koppelelement ist dabei aus einem η-Abschnitt mit einer Serienkapazität und zwei Shunt-Zweigen gebildet.

Das Dokument GB 864,444 zeigt einen Eingangsschaltkreis eines Empfängers. Es ist eine Aufteilung auf zwei Bänder vorgesehen. Zwischen die beiden Abstimmkreise und Masse ist eine Koppelkapazität geschaltet. Ein Parallelresonanzkreis verbindet eine Antenne mit den beiden Abstimmkreisen.

Aufgabe der vorliegenden Erfindung ist es, eine eingangs genannte Hochfrequenz-Eingangsstufe derart weiterzubilden, daß diese einen einfachen Schaltungsaufbau aufweist, bezüglich gegenseitiger Störungen der einzelnen Bänder verbessert und kostengünstig herstellbar ist.

Erfindungsgemäß wird die Aufgabe bei einer eingangs genannten Hochfrequenz-Eingangsstufe gelöst, bei der das Koppelelement ein kapazitives Element aufweist, welches einerseits direkt mit dem ersten und zweiten Hochfrequenz-Resonanzkreis und andererseits direkt mit einem Bezugspotential-Anschluß gekoppelt ist.

Die Hochfrequenz-Eingangsstufe kommt ohne Umschalter zwischen den einzelnen Abstimmkreisen aus. Jeder Hochfrequenz-Resonanzkreis kann für ein eigenes Frequenzband ausgelegt sein. Die einzelnen Frequenzbänder können benachbart sein. Das kapazitive Element, welches einen Tiefpaß bildet, unterdrückt wirksam die unerwünschten Einflüsse insbesondere des niedrigen und gegebenenfalls mittleren Frequenzbandes in das hohe Frequenzband.

Die Aufteilung eines beispielsweise an einer Antenne einkoppelnden Hochfrequenz-Empfangssignals in die verschiedenen Frequenzbänder beziehungsweise Resonanzkreise erfolgt durch eine einfache Parallelschaltung. Dabei sind keine Schaltdioden erforderlich. Die beschriebene Anordnung ist in einfacher und kostengünstiger Weise realisierbar und bezüglich der Unterdrückung unerwünschter Einflüsse auf jeweils nicht gewählte Bänder verbessert.

Gemäß der vorliegenden Erfindung weist das Hochfrequenz-Koppelelement ein Hochpaßfilter auf. Beispielsweise bei einem Fernseh- oder Radio-Empfang ist das gewünschte Frequenzband oder sind die gewünschten Frequenzbänder nicht nahe 0 Hertz, so daß mit einem Hochpaßfilter unerwünschte, unterhalb der gewünschten Frequenzbänder liegende Frequenzen unterdrückt werden können.

In einer weiteren, vorteilhaften Ausführungsform der vorliegenden Erfindung umfaßt das Hochpaßfilter eine Induktivität, welche einerseits mit der Luftschnittstelle und den Hochfrequenz-Resonanzkreisen und andererseits mit dem Bezugspotential verbunden ist. Hierdurch ist eine besonders einfache Realisierung eines Hochpaßfilters ermöglicht.

In weiteren, vorteilhaften Ausführungsform der vorliegenden Erfindung ist ein dritter, abstimmbarer Hochfrequenz-Resonanzkreis vorgesehen, welcher parallel zu erstem und zweiten Hochfrequenz-Resonanzkreis geschaltet ist. Mit einem dritten, abstimmbaren Hochfrequenz-Resonanzkreis kann ein Dreiband-TV-Tuner realisiert sein, welcher beispielsweise in einem ersten Frequenzband einen Bereich 470 bis 960 MHz, in einem zweiten Frequenzband einen Bereich von 160 bis 470 MHz und in einen dritten Bereich einen Frequenzumfang von 40 bis 160 MHz umfassen kann.

Gemäß der vorliegenden Erfindung weisen die Hochfrequenz-Resonanzkreise eingangsseitig je eine Serieninduktivität zur Impedanzwandlung auf, welche jeweils einerseits direkt mit dem Koppelelement verbunden sind. Die Impedanzwandlung ist insbesondere dahingehend vorteilhaft, um die sich durch das Abstimmen des Resonanzkreises ändernde Impedanz desselben an diejenige der Luftschnittstelle anzupassen.

In einer weiteren, vorteilhaften Ausführungsform der vorliegenden Erfindung weisen die Hochfrequenz-Resonanzkreise je eine Induktivität parallel zu einer Serienschaltung aus einer Kapazitätsdiode und einer Kapazität auf. Die Resonanzkreise können mittels einer gemeinsamen Abstimmspannung dadurch regelbar sein, daß die Kapazitätsdioden jeweils eine veränderbare Kapazität haben.

In einer weiteren, vorteilhaften Ausführungsform der vorliegenden Erfindung ist zwischen dem mit dem Koppelelement verbundenen Eingang und einem mit einem Verstärker gekoppelten Ausgang der Hochfrequenz-Resonanzkreise je eine Kapazität zur Unterdrückung von Spiegelfrequenzen geschaltet. Die Unterdrückung von Spiegelfrequenzen kann beispielsweise dann wünschenswert sein, wenn Mischer zum Konvertieren eines verstärkten Ausgangssignal der Resonanzkreise in ein Zwischenfrequenzsignal vorgesehen sind.

In einer weiteren, vorteilhaften Ausführungsform der vorliegenden Erfindung ist zwischen Serien-Induktivität und einem mit einem Verstärker gekoppelten Ausgang der Hochfrequenz-Resonanzkreise eine Kapazität zur Vergrößerung der Bandbreite des jeweiligen Resonanzkreises geschaltet.

Gemäß der vorliegenden Erfindung weist das Koppelelement ein erstes Bandsperrfilter zur Unterdrückung unerwünschter Zwischenfrequenzen auf.

In einer weiteren, vorteilhaften Ausführungsform der vorliegenden Erfindung weist das Koppelelement ein zweites Bandsperrfilter zur Unterdrückung weiterer unerwünschter Frequenzen, welches dem ersten Bandsperrfilter vorgeschaltet ist, auf. Beispielsweise kann das zweite Bandsperrfilter so ausgelegt sein, daß es Signale im Frequenzbereich des sogenannten Citizen Band, CB unterdrückt. Erstes und zweites Bandsperrfilter können beispielsweise mit einer zu einer Kapazität parallel geschalteten Induktivität realisiert sein und eingangsseitig beispielsweise an eine Antenne und ausgangsseitig an die Eingänge der Resonanzkreise angeschlossen sein. Erstes und zweites Bandsperrfilter können dabei zueinander in Serie geschaltet sein, wobei das Zwischenfrequenz-Bandsperrfilter vorteilhafterweise dem zweiten Bandsperrfilter nachgeschaltet ist. Insbesondere kann dabei zwischen den Bandsperrfiltern ein Verbindungsknoten gebildet sein, an dem das Hochpaßfilter angeschlossen sein kann.

In einer weiteren, vorteilhaften Ausführungsform der vorliegenden Erfindung schließlich hat das kapazitive Element einen Kapazitätswert von 0,5 Picofarad und die Hochfrequenz-Eingangsstufe umfaßt insgesamt einen Abstimmbereich von 40 bis 870 MHz.

Der erste Hochfrequenz-Resonanzkreis kann dabei für ein hohes, der zweite Hochfrequenz-Resonanzkreis für ein mittleres und der dritte Hochfrequenz-Resonanzkreis für ein niedriges Frequenzband ausgelegt sein. Das tiefpaßbildende, kapazitive Element kann in einer praktischen Schaltungsrealisierung vorteilhafterweise näher am zweiten Hochfrequenz-Resonanzkreis als am ersten Hochfrequenz-Resonanzkreis angeordnet sein, sodaß sich mit jenem eine kürzere Verbindung als mit diesem ergibt, wobei das Koppelelement näher am Eingang des ersten Hochfrequenz-Resonanzkreises als am Eingang des zweiten Hochfrequenz-Resonanzkreises angeschlossen sein kann.

Weitere Einzelheiten der Erfindung sind in den Unteransprüchen angegeben.

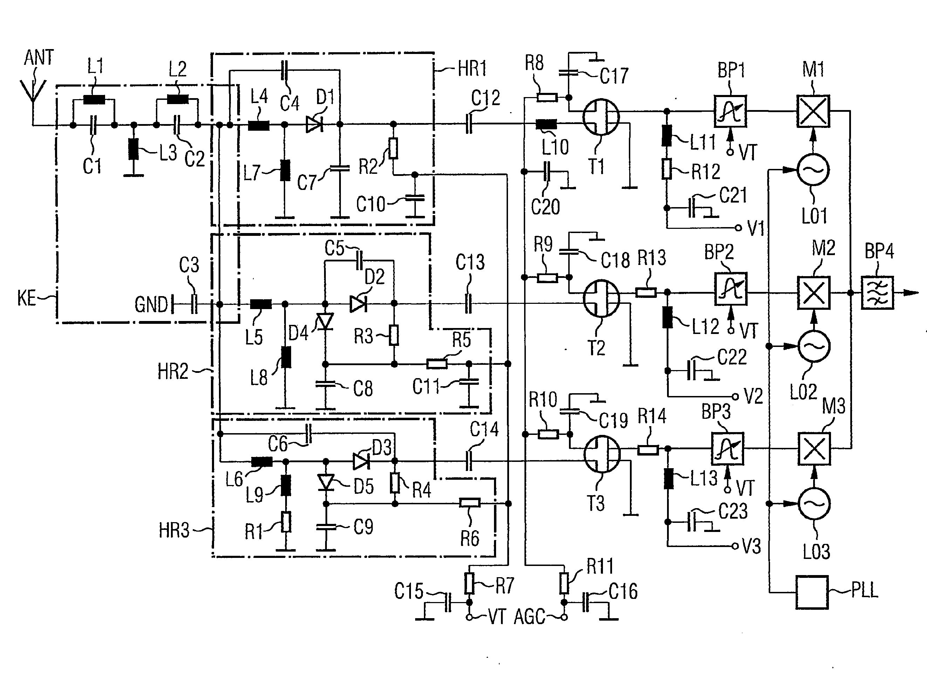

Die Erfindung wird nachfolgend an einem Ausführungsbeispiel anhand der Zeichnung näher erläutert.

Es zeigt:

Die Figur ein Schaltbild einer beispielhaften Ausführungsform einer Hochfrequenz-Eingangsstufe.

Die Figur zeigt einen Dreiband-TV-Tuner mit einer Antenne ANT, einem an die Antenne ANT angeschlossenen Koppelelement KE und drei parallelgeschalteten, an das Koppelelement angeschlossenen Hochfrequenz-Resonanzkreisen HR1, HR2 und HR3. Den Hochfrequenz-Resonanzkreisen HR1, HR2, HR3 ist jeweils ein als Verstärker geschalteter Transistor T1, T2, T3 nachgeschaltet. Schließlich wird das so verstärkte Signal in einer Mischerstufe M1, M2, M3 von einem Hochfrequenz-Signal in ein Zwischenfrequenz-Signal heruntergemischt.

Im einzelnen umfaßt das Koppelelement KE ein an die Antenne ANT angeschlossenes zweites Bandsperrfilter L1, C1, welches aus einer Kapazität C1 mit parallel geschalteter Induktivität L1 gebildet ist und zur Unterdrückung unerwünschter CB-Funkfrequenzen dient. Diesem zweiten Bandsperrfilter L1, C1 ist eine als Hochpaßfilter wirkende Induktivität L3 nachgeordnet, welche gegen Masse GND geschaltet ist. Im weiteren Signalverlauf ist ein erstes Bandsperrfilter L2, C2, eine Kapazität LC2 mit parallel geschalteter Induktivität L2 umfassend, welches zur Unterdrückung unerwünschter Zwischenfrequenzen dient, vorgesehen. Schließlich weist das Koppelelement KE ein an das erste Bandsperrfilter L2, C2 sowie an die Eingänge der dem Koppelelement KE nachgeschalteten Hochfrequenz-Resonanzkreise HR1, HR2, HR3 angeschlossenes kapazitives, tiefpaßbildendes Element C3 auf, welches an einem Ende mit einem Bezugspotentialanschluß GND verbunden ist.

Die Hochfrequenz-Resonanzkreise HR1, HR2, HR3 sind jeweils einem bestimmten TV-Frequenzband zugeordnet, wobei der erste Hochfrequenz-Resonanzkreis HR1 für das UHF(Ultra-High Frequency)-Band, der zweite Hochfrequenz-Resonanzkreis HR2 für das hohe VHF(Very High Frequency)-Frequenzband und der dritte Hochfrequenz-Resonanzkreis HR3 für das niedrige VHF-Frequenzband ausgelegt ist.

Die Hochfrequenz-Resonanzkreise HR1, HR2, HR3 weisen jeweils eingangsseitig eine als Serien-Induktivität geschaltete Induktivität L4, L5, L6, welche zur Impedanzwandlung dient, auf. Der eigentliche Resonanzkreis ist mit jeweils einer nachgeschalteten Induktivität L7, L8, L9 gegen Masse, sowie einer dazu parallel geschalteten Serienschaltung, welche eine abstimmbare Kapazitätsdiode D1, D4, D5 und eine Kapazität C7, C8, C9 umfaßt, gebildet. Die Resonanzfrequenz der Hochfrequenz-Resonanzkreise HR1, HR2, HR3 kann jeweils mit einer gemeinsamen Abstimmspannung VT, welche jeweils über einer Widerstand R2, R5, R6 an die Kapazitätsdiode D1, D4, D5 angeschlossen ist, eingestellt werden. In den für niedrigere Frequenzen geeigneten Abstimmkreisen HR2, HR3 kann eine weitere als Kapazitätsdiode ausgebildete Serienkapazität D2, D3, vorgesehen sein. Der für das niedrigere VHF-Frequenzband geeignete, dritte Abstimmkreis HR3 weist zusätzlich einen Widerstand R1 in Serie zur Induktivität L9 auf. Zur Unterdrückung von Spiegelfrequenzen weisen erster und dritter Hochfrequenz-Resonanzkreis HR1, HR3 jeweils eine Kapazität C4, C6 auf, welche parallel zur Serienschaltung aus Induktivität L4, L6 und Kapazitätsdiode D1, D3 geschaltet ist. Der zweite Hochfrequenz-Referenzkreis HR2 weist eine Kapazität C5 auf, welche zur Diode D2 mit dem Zweck parallel geschaltet ist, die Bandbreite beziehungsweise den Abstimmbereich des zweiten Hochfrequenz-Resonanzkreises HR2 zu vergrößern. Für die Zuführung der Abstimmspannung VT ist ein RC-Glied R7, C15 vorgesehen. In den drei weiteren Signalpfaden der drei Bänder ist dem Hochfrequenz-Resonanzkreis HR1, HR2, HR3 jeweils eine Koppelkapazität C12, C13, C14 nachgeschaltet, welche einerseits mit dem Hochfrequenz-Resonanzkreis HR1, HR2, HR3 und andererseits mit einem Gate-Anschluß eines FeldeffektTransistors T1, T2, T3 verbunden ist. Die Dual-Gate-Transistoren T1, T2, T3 weisen einen zweiten Gate-Anschluß auf, dem ein AGC (Automatic Gain Control)-Signal über einen gemeinsamen Widerstand R11 sowie je einen Widerstand R8, R9, R10 zuführbar. Die Transistoren T1, T2, T3 können dabei zugleich zur Bandselektion herangezogen werden. An die Widerstände R8, R9, R10, R11 ist jeweils an einem Ende eine Entkopplungskapazität C16, C17, C18, C19 gegen Masse geschaltet. Der Source-Anschluß der Transistoren T1, T2, T3 ist mit dem Bezugspotential-Anschluß GND verbunden. An den Drain-Anschlüssen der Transistoren T1, T2, T3 ist über je eine Induktivität L11, L12, L13 und entkoppelt mittels gegen Masse geschalteter Kapazitäten C21, C22, C23 je eine Versorgungsspannung V1, V2, V3 zuführbar. Weiterhin ist an die Drain-Anschlüsse der Transistoren T1, T2, T3 je ein mit der Abstimmspannung VT abstimmbares Bandpaßfilter BP1, BP2, BP3 sowie ein ausgangsseitig angeschlossener Mischer M1, M2, M3 angeschlossen. Die Mischer M1, M2, M3 dienen zum Umsetzen des verstärkten Eingangssignal in ein Zwischenfrequenz-Signal. Weiterhin ist je ein Lokaloszillator LO1, LO2, LO3 vorgesehen, der im Zusammenwirken mit einer Phasenregelschleife PLL eine von der Abstimmfrequenz der Hochfrequenz-Resonanzkreise HR1, HR2, HR3 abhängige Frequenz derart bereitstellt, daß an den Mischerausgängen ein Zwischenfrequenzsignal fester Frequenz ableitbar ist.

Die Mischerausgänge sind miteinander am Eingang eines Bandpaßfilters BP4 verbunden, an dessen Ausgang ein gefiltertes Zwischenfrequenzsignal ableitbar ist.

Die Kapazität C3 ermöglicht eine wirksame Unterdrückung insbesondere von Einflüssen des mittleren und des unteren Frequenzbandes in das hohe UHF-Frequenzband. Insgesamt ist in der beschriebenen Schaltungsanordnung bei Selektion oder Betrieb eines Frequenzbandes der Einfluß unerwünschter Störungen der jeweils anderen Frequenzbänder wirksam unterdrückt. Der Dreiband-TV-Tuner gemäß der Figur benötigt zum Umschalten zwischen den einzelnen Bändern keine Schaltdioden. Die beschriebene Eingangsstufe weist eine einfache, mit geringem Chipflächenbedarf, geringem Aufwand und kostengünstig herstellbare Schaltung auf. Lediglich eine zusätzliche Kapazität C3 ermöglicht ein einfaches Parallelschalten der Signalpfade für die einzelnen Bänder vom Resonanzkreis bis zum Mischer. Die Kapazität C3 wirkt dabei als Tiefpaßfilter.

Das beschriebene Schaltungsprinzip ist nicht auf die Anwendung in Fernseh- oder Videogeräte-Tunern beschränkt, sondern kann je nach Verwendungszweck auch in anderen Hochfrequenz-Anwendungen eingesetzt werden.

## Patentansprüche

1. Hochfrequenz-Eingangsstufe mit
einem Hochfrequenz-Koppelelement (KE), dem einzangsseitig ein Eingangssignal zuführbar ist und das ausgangsseitig einem ersten und mit einem zweiten abstimmbaren Hochfrequenz-Resonanzkreis (HR1, HR2), welche eingangsseitig miteinander verbunden sind, gekoppelt ist,
**dadurch gekennzeichnet, daß**
- das Hochfrequenz-Koppelelement (KE) ein Hochpaßfilter aufweist,
- das Hochfrequenz-Koppelelement (KE) ein erstes Bandsperrfilter zur Unterdrückung unerwünschter Zwischenfrequenzen (L2, C2) aufweist, das dem Hochpaßfilter nachgeschaltet ist,
- das Hochfrequenz-Koppelelement (KE) ein kapazitives Element (C3) aufweist, welches dem ersten Bandsperrfilter (L2, C2) nachgeschaltet ist und welches einerseits direkt mit dem ersten und zweiten Hochfrequenz-Resonanzkreis (HR1, HR2) und andererseits direkt mit einem Bezugspotential-Anschluß (GND) verbunden ist, und
- die Hochfrequenz-Resonanzkreise (HR1, HR2, HR3) eingangsseitig je eine Serien-Induktivität (L4, L5, L6) zur Impedanzwandlung aufweisen, welche einerseits direkt mit dem Hochfrequenz-Koppelelement (KE) verbunden sind, und dabei je dem ersten Bandsperrfilter (L2, C2) nachgeschaltet sind.

2. Hochfrequenz-Eingangsstufe nach Anspruch 1,
**dadurch gekennzeichnet, daß**
das Hochpaßfilter eine Induktivität (L3) umfaßt, welche einerseits mit der Luftschnittstelle (ANT) und den Hochfrequenz-Resonanzkreisen (HR1, HR2) und andererseits mit dem Bezugspotential (GND) verbunden ist.

3. Hochfrequenz-Eingangsstufe nach Anspruch 1 oder 2,
**dadurch gekennzeichnet, daß**
ein dritter, abstimmbarer Hochfrequenz-Resonanzkreis (HR3) vorgesehen ist, welcher parallel zum ersten und zweiten Hochfrequenz-Resonanzkreis (HR1, HR2) geschaltet ist.

4. Hochfrequenz-Eingangsstufe nach einem der Ansprüche 1 bis 3,
**dadurch gekennzeichnet, daß**
die Hochfrequenz-Resonanzkreise (HR1, HR2, HR3) jeweils eine Induktivität (L7, L8, L9) parallel zu einer Serienschaltung aus einer Kapazitätsdiode (D1, D4, D5) und einer Kapazität (C7, C8, C9) aufweisen.

5. Hochfrequenz-Eingangsstufe nach einem der Ansprüche 1 bis 4,
**dadurch gekennzeichnet, daß**
zwischen einem mit dem Koppelelement (KE) verbundenen Eingang und einem mit einem Verstärker (T1, T3) gekoppelten Ausgang der Hochfrequenz-Resonanzkreise (HR1, HR3) je eine Kapazität (C4, C6) zur Unterdrückung von Spiegelfrequenzen geschaltet ist.

6. Hochfrequenz-Eingangsstufe nach einem der Ansprüche 1 bis 5,
**dadurch gekennzeichnet, daß**
zwischen Serien-Induktivität (L5) und einem mit einem Verstärker (T2) gekoppelten Ausgang eines der Hochfrequenz-Resonanzkreise (HR2) eine Kapazität (C5) geschaltet ist.

7. Hochfrequenz-Eingangsstufe nach einem der Ansprüche 1 bis 6,
**dadurch gekennzeichnet, daß**
das Koppelelement (KE) ein zweites Bandsperrfilter (L1, C1), welches dem ersten Bandsperrfilter (L2, C2) vorgeschaltet ist, aufweist.

8. Hochfrequenz-Eingangsstufe nach einem der Ansprüche 1 bis 7,
**dadurch gekennzeichnet, daß**
das kapazitive Element (C3) einen Kapazitätswert von 0,5 Picofarad hat und die Hochfrequenz-Eingangsstufe einen gesamten Abstimmbereich von 40 bis 870 MHz umfaßt.

9. Hochfrequenz-Eingangsstufe nach einem der Ansprüche 1 bis 8,
**dadurch gekennzeichnet, daß**
das Koppelelement (KE) zur Zuführung des Eingangssignals mit einer Antenne (ANT) verbunden ist.

## Claims

1. Radio-frequency input stage having
a radio-frequency coupling element (KE) to which an input signal can be supplied on the input side and which is coupled on the output side to a first and to a second tunable radio-frequency resonant circuit (HR1, HR2), which are connected to one another on the input side,
**characterized in that**
- the radio-frequency coupling element (KE) has a high-pass filter,
- the radio frequency coupling element (KE) has a first bandstop filter for suppressing undesirable intermediate frequencies (L2, C2), which is connected downstream of the high-pass filter,
- the radio-frequency coupling element (KE) has a capacitive element (C3) which is connected downstream of the first bandstop filter (L2, C2) and is connected directly on one side to the first and second radio-frequency resonant circuits (HR1, HR2) and directly on the other side to a reference-earth potential connection (GND), and
- the radio-frequency resonant circuits (HR1, HR2, HR3) are connected on the input side to a respective series inductance (L4, L5, L6) for impedance conversion, and these are connected directly on one side to the radio-frequency coupling element (KE) and are thereby in each case connected downstream of the first bandstop filter (L2, C2).

2. Radio-frequency input stage according to Claim 1,
**characterized in that**
the high-pass filter has an inductance (L3), which is connected on one side to the air interface (ANT) and to the radio-frequency resonant circuits (HR1, HR2), and on the other side to the reference-earth potential (GND).

3. Radio-frequency input stage according to Claim 1 or 2,
**characterized in that**
a third, tunable radio-frequency resonant circuit (HR3) is provided, and is connected in parallel with the first and second radio-frequency resonant circuits (HR1, HR2).

4. Radio-frequency input stage according to one of Claims 1 to 3,
**characterized in that**
the radio-frequency resonant circuits (HR1, HR2, HR3) have a respective inductance (L7, L8, L9) in parallel with a series circuit formed from a capacitance diode (D1, D4, D5) and a capacitance (C7, C8, C9).

5. Radio-frequency input stage according to one of Claims 1 to 4,
**characterized in that**
a capacitance (C4, C6) for suppressing mirror-image frequencies is in each case connected between an input, which is connected to the coupling element (KE), and an output, which is coupled to an amplifier (T1, T3), of the radio-frequency resonant circuits (HR1, HR3).

6. Radio-frequency input stage according to one of Claims 1 to 5,
**characterized in that**
a capacitance (C5) is connected between the series inductance (L5) and an output, which is coupled to an amplifier (T2), of one of the radio-frequency resonant circuits (HR2).

7. Radio-frequency input stage according to one of Claims 1 to 6,
**characterized in that**
the coupling element (KE) has a second bandstop filter (L1, C1), which is connected upstream of the first bandstop filter (L2, C2).

8. Radio-frequency input stage according to one of Claims 1 to 7,
**characterized in that**
the capacitive element (C3) has a capacitance value of 0.5 picofarads, and the radio-frequency input stage has an overall tuning range from 40 to 870 MHz.

9. Radio-frequency input stage according to one of Claims 1 to 8,
**characterized in that**
the coupling element (KE) is connected to an antenna (ANT) in order to supply the input signal.

## Revendications

1. Étage d'entrée à haute fréquence, avec un élément de couplage à haute fréquence (KE) auquel un signal d'entrée peut être envoyé côté entrée et qui est couplé côté sortie à un premier et un deuxième circuit résonant à haute fréquence (HR1, HR2) qui sont reliés ensemble côté entrée,
**caractérisé par le fait que**
- l'élément de couplage à haute fréquence (KE) comporte un filtre passe-haut,
- l'élément de couplage à haute fréquence (KE) comporte un premier filtre coupe-bande (L2, C2) qui est destiné à la suppression de fréquences intermédiaires indésirables et qui est branché du côté aval du filtre passe-haut,
- l'élément de couplage à haute fréquence (KE) comporte un élément capacitif (C3) qui est branché du côté aval du premier filtre coupe-bande (L2, C2) et qui est relié d'une part directement au premier et au deuxième circuit résonant à haute fréquence (HR1, HR2) et d'autre part directement à une borne de potentiel de référence (GND), et
- les circuits résonants à haute fréquence (HR1, HR2, HR3) comportent chacun côté entrée une inductance série (L4, L5, L6) pour la transformation d'impédance, lesquelles inductances sont reliées d'une part directement à l'élément de couplage à haute fréquence (KE) et sont branchées alors à chaque fois du côté aval du premier filtre coupe-bande (L2, C2) .

2. Étage d'entrée à haute fréquence selon la revendication 1,
**caractérisé par le fait que** le filtre passe-haut comprend une inductance (L3) qui est reliée d'une part à l'interface radio (ANT) et aux circuits résonants à haute fréquence (HR1, HR2) et d'autre part au potentiel de référence (GND).

3. Étage d'entrée à haute fréquence selon la revendication 1 ou 2,
**caractérisé par le fait qu'**il est prévu un troisième circuit résonant à haute fréquence accordable (HR3) qui est branché en parallèle avec le premier et le deuxième circuit résonant à haute fréquence (HR1, HR2).

4. Étage d'entrée à haute fréquence selon l'une des revendications 1 à 3,
**caractérisé par le fait que** les circuits résonants à haute fréquence (HR1, HR2, HR3) comportent chacun une inductance (L7, L8, L9) en parallèle avec un circuit série composé d'une diode capacitive (D1, D4, D5) et d'une capacité (C7, C8, C9).

5. Étage d'entrée à haute fréquence selon l'une des revendications 1 à 4,
**caractérisé par le fait qu'**une capacité (C4, C6) pour la suppression de fréquences images est branchée à chaque fois entre une entrée, reliée à l'élément de couplage (KE), des circuits résonants à haute fréquence (HR1, HR3) et une sortie, couplée à un amplificateur (T1, T3), de ces mêmes circuits résonants à haute fréquence.

6. Étage d'entrée à haute fréquence selon l'une des revendications 1 à 5,
**caractérisé par le fait qu'**une capacité (C5) est branchée entre l'inductance série (L5) et une sortie, couplée à un amplificateur (T2), de l'un des circuits résonants à haute fréquence (HR2).

7. Étage d'entrée à haute fréquence selon l'une des revendications 1 à 6,
**caractérisé par le fait que** l'élément de couplage (KE) comporte un deuxième filtre coupe-bande (L1, C1) qui est branché du côté amont du premier filtre coupe-bande (L2, C2).

8. Étage d'entrée à haute fréquence selon l'une des revendications 1 à 7,
**caractérisé par le fait que** l'élément capacitif (C3) a une valeur capacitive de 0,5 pF et que l'étage d'entrée à haute fréquence comprend une plage d'accord totale de 40 à 870 MHz.

9. Étage d'entrée à haute fréquence selon l'une des revendications 1 à 8,
**caractérisé par le fait que** l'élément de couplage (KE) est relié à une antenne (ANT) pour l'amenée du signal d'entrée.
